# EUROPÄISCHE PATENTSCHRIFT

(11) **EP 0 988 633 B1**
(45) Veröffentlichungstag und Bekanntmachung des Hinweises auf die Patenterteilung: **09.05.2001**
(21) Anmeldenummer: 98936116.7
(22) Anmeldetag: 08.06.1998
(51) Int. Cl.: G11C 16/06

(54) **ANSTEUERSCHALTUNG FÜR NICHTFLÜCHTIGE HALBLEITER-SPEICHERANORDNUNG**
CONTROL CIRCUIT FOR A NON-VOLATILE SEMI-CONDUCTOR MEMORY SYSTEM
CIRCUIT DE PILOTAGE D'UN AGENCEMENT DE MEMOIRE REMANENTE SEMI-CONDUCTRICE

(30) Priorität: 13.06.1997 DE 19725181
(43) Veröffentlichungstag der Anmeldung: 29.03.2000
(73) Patentinhaber: Infineon Technologies AG, 81669 München (DE)
(72) Erfinder: ZETTLER, Thomas, D-81737 München (DE)
(74) Vertreter: Zedlitz, Peter, Dipl.-Inf.
(86) Internationale Anmeldenummer: DE9801560
(87) Internationale Veröffentlichungsnummer: WO9858384

(56) Entgegenhaltungen:
- EP-A- 0 154 379
- EP-A- 0 208 186
- US-A- 4 716 312
- US-A- 5 444 396
- MASAKI MOMODOMI ET AL: "AN EXPERIMENTAL 4-MBIT CMOS EEPROM WITH A NAND-STRUCTURED CELL" IEEE JOURNAL OF SOLID-STATE CIRCUITS, Bd. 24, Nr. 5, 1. Oktober 1989, Seiten 1238-1243, XP000066265

## Beschreibung

Die vorliegende Erfindung betrifft eine Ansteuerschaltung für eine nichtflüchtige Halbleiterspeicheranordnung, mit einer Pegelwandlerschaltung, die einen Ausgangswert und einen zu diesem Ausgangswert komplementären Ausgangswert an eine Bitleitung und/oder eine Wortleitung der Halbleiterspeicheranordnung anlegt, und mit einer zwischen einer Eingabeschaltung und der Pegelwandlerschaltung liegenden Verriegelungsschaltung (Latch), die die in der Halbleiterspeicheranordnung zu speichernden Daten zwischenspeichert.

Eine solche Ansteuerschaltung ist aus der EP 0 154 379 A2 bekannt.

Nichflüchtige Halbleiter-Speicheranordnungen, wie beispielsweise Flash-Speicher und elektrisch löschbare programmierbare Festwertspeicher (EEPROM) benötigen zum Aufbringen bzw. Entfernen von Ladungen und damit Daten aus den einzelnen Speicherzellen Spannungen von typischerweise 15 V. Diese Spannungen, die die normale Versorgungsspannung Vdd, die in der Größenordnung 5 V liegt, wesentlich übersteigen, werden im folgenden auch als "Hochspannungen" bezeichnet. Je nach der Betriebsart werden die Hochspannungen an Wortleitungen oder Bitleitungen oder auch an Wortleitungen und Bitleitungen einer Halbleiter-Speicheranordnung angelegt.

Fig. 3 veranschaulicht schematisch den Aufbau einer sogenannten Stapel-Gate-Zelle. Diese Stapel-Gate-Zelle weist eine Source-Zone 1 und eine Drain-Zone 2 in einem Halbleitersubstrat 3 auf. Die Source-Zone 1 und die Drain-Zone 2 sind beide n⁺-dotiert, während das Halbleitersubstrat 3 eine p-Dotierung hat. Die Source-Zone 1 und die Drain-Zone 2 sowie der Kanalbereich des Halbleitersubstrates 3 zwischen der Source-Zone 1 und der Drain-Zone 2 sind mit einer Tunneloxidschicht 4 aus beispielsweise Siliciumdioxid versehen. Auf der Tunneloxidschicht 4 befindet sich im Bereich zwischen der Drain-Zone 2 und der Source-Zone 1 ein Floating Gate 5 aus beispielsweise polykristallinem Silicium. Auf diesem Floating Gate 5 sind noch ein Zwischenpolydielektrikum 6 und ein Steuergate 7 angeordnet.

Zum Löschen und Programmieren von Daten kann bei einer solchen Stapel-Gate-Zelle das sogenannte "Fowler-Nordheim-Tunneln" (FN-Tunneln) angewandt werden. Bei einem Löschvorgang werden beispielsweise 0 V an die Drain-Zone 2 und +15 V an das Steuergate 7 angelegt. Dann tunneln Elektronen aus dem Kanalbereich durch die Tunneloxidschicht 4 in das Floating Gate 5. Beim Programmieren liegen beispielsweise 0 V am Steuergate 7 und +15 V an der Drain-Zone 2, was Elektronen aus dem Floating Gate 5 durch die Tunneloxidschicht 4 in die Drain-Zone 2 tunneln läßt. Es ist aber auch möglich, zum Programmieren beispielsweise -11 V an das Steuergate 7 und +4 V an die Drain-Zone 2 anzulegen. Auch hierdurch werden Elektronen veranlaßt, aus dem Floating Gate 5 in die Drain-Zone 2 zu tunneln.

Beim Programmieren mit heißen Elektronen ("hot-e-Programmieren") werden an das Steuergate 7 beispielsweise +15 V, an die Drain-Zone 2 +5V und an die Source-Zone 1 0 V angelegt. Dadurch wandern Elektronen aus der Drain-Zone 2 zur Source-Zone 1 und tunneln gleichzeitig durch die Tunneloxidschicht 4 in das Floating Gate 5.

Ein EEPROM ist bekanntlich byteweise programmierbar und löschbar, während ein Flash-Speicher durch heiße Elektronen oder FN-Tunneln byteweise programmierbar und durch FN-Tunneln blockweise löschbar ist.

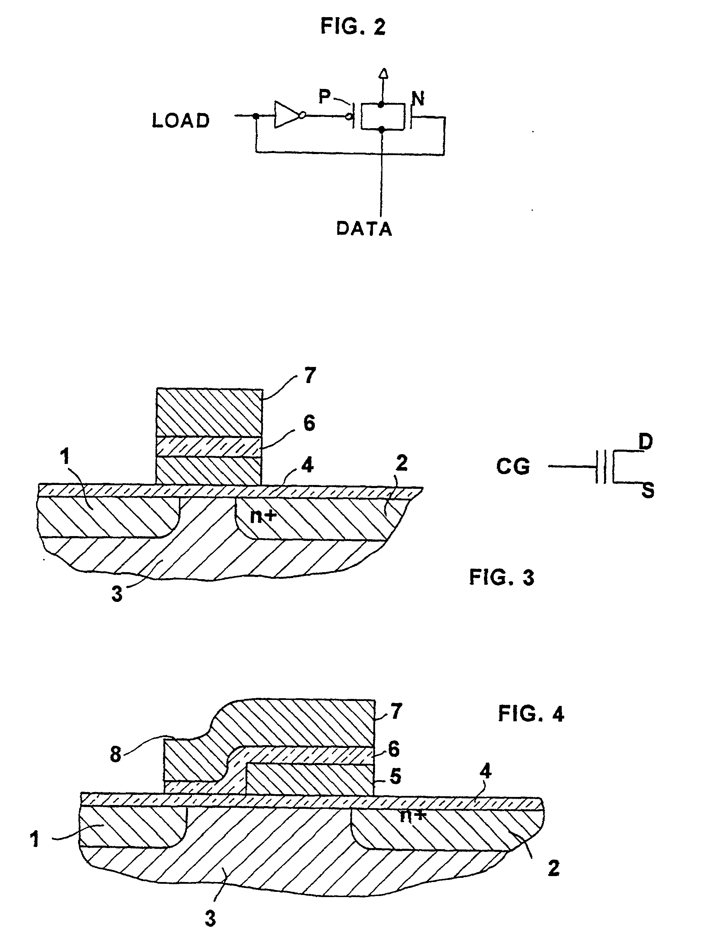

Fig. 4 zeigt als anderen Speicherzellentyp eine sogenannte Split-Gate-Zelle mit einem Halbleitersubstrat 3, einer n⁺-dotierten Source-Zone 1, einer n⁺-dotierten Drain-Zone 2, einer Tunneloxidschicht 4, einem Floating Gate 5, einem Zwischenpolydielektrikum 6 und einem Steuergate 7. Der "abgesenkte" Teil des Steuergates 7 wird auch als Seriengate 8 bezeichnet, da das erhöhte Steuergate 7 und das Seriengate 8 als miteinander verbundene Gates von zwei in Reihe geschalteten NMOS-Transistoren angesehen werden können.

Die in Fig. 3 gezeigte Stapelzelle wird durch ein in dieser Figur rechts dargestelltes Symbol wiedergegeben, wobei "CG" das Steuergate 7, "D" den Anschluß der Drain-Zone 2 und "S" den Anschluß der Source-Zone 1 bedeutet.

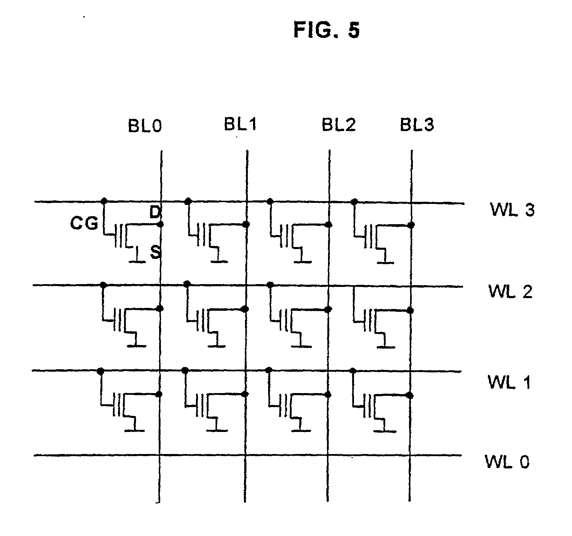

Speicherzellen der in Fig. 3 gezeigten Art können einen Halbleiterspeicher mit Bitleitungen BL0, BL1, BL2, BL3 und Wortleitungen WL0, WL1, WL2 und WL3 bilden, wie dies schematisch in Fig. 5 angedeutet ist.

Bei einer Halbleiter-Speicheranordnung müssen Hochspannungen selektiv an ausgewählte Wortleitungen bzw. Bitleitungen anlegbar sein, um einzelne Speicherzellen zu löschen oder zu programmieren. Neben Halbleiter-Speicheranordnungen müssen aber auch speziell geregelte Spannungen mit einer höheren Konstanz als die Versorgungsspannung durch Hochspannungen von beispielsweise 15 V geschaltet werden.

Ein wichtiger Anwendungsfall ist beispielsweise die Ansteuerung der Bitleitungen bei Flash-Speichern mit negativer Programmierspannung (vergleiche hierzu beispielsweise R. Heinrich, W. Heinrigs, G. Tempel, J. Winnerl, T. Zettler, in Proc. of the International Electron Device Meeting (IEDM), 1993, Seiten 445 bis 448). Zur Erzielung konstanter Programmierbedingungen wird hier beispielsweise die Bitleitungsspannung auf 5 V geregelt, während an den Wortleitungen -12 V anliegen. Auch solche geregelte Spannungen von beispielsweise 5 V, die unter der Versorgungsspannung von 5,5 V liegen, werden im folgenden unter "Hochspannung" verstanden.

Zur Erzeugung derartiger Ansteuerspannungen wird eine Ansteuerschaltung benötigt, die die gewünschten Spannungen mit hoher Konstanz und geringem Flächenbedarf liefern soll.

Im Einzelnen ist in der US-A-5, 293, 561 eine Ansteuerschaltung mit einer Spannungsverteilerschaltung für die separate Versorgung von Speicherfeld und Speicher für Redundanzeinstellungen mit Hochspannungen beschrieben. Diese bekannte Ansteuerschaltung hat insbesondere eine Pegelwandlerschaltung, die einen Ausgangswert und einen zu diesem Ausgangswert komplementären Ausgangswert an eine Halbleiter-Speicheranordnung anzulegen vermag.

Es hat sich aber gezeigt, daß die bekannte Ansteuerschaltung gemäß der US-A-5,293,561 für die Bitleitungsansteuerung wenig geeignet ist, da sie keine Zwischenspeicherung von Daten ermöglicht. Außerdem enthält die bekannte Ansteuerschaltung NMOS-Transistoren vom Verarmungstyp, die als zusätzliche Bauelemente einen beträchtlichen technologischen Aufwand bedingen.

Die Ansteuerschaltung gemäß der EP 0 154 379 A2 enthält hingegen eine große Zahl von PMOS-Transistoren, die einen relativ großen Flächenbedarf und eine geringere Stromergiebigkeit haben.

Es ist daher **Aufgabe** der vorliegenden Erfindung, eine Ansteuerschaltung für eine nichtflüchtige Halbleiter-Speicheranordnung zu schaffen, die mit möglichst wenigen Bauelementen auf kleiner Fläche realisierbar ist, so daß sie auf engstem Raum im Raster der Speichermatrix der HalbleiterSpeicheranordnung aufgebaut werden kann, und die Ansteuerspannungen mit hoher Konstanz auch im Hochspannungsbereich abzugeben vermag.

Zur Lösung dieser Aufgabe ist eine Ansteuerschaltung der eingangs genannten Art mit den kennzeichnenden Merkmalen des Anspruchs 1 ausgebildet.

Die Eingabeschaltung ist in erfindungsgemäßer Weise aus einem mit seiner Source-Drain-Strecke zwischen einem Dateneingang und einem ersten Datenausgang liegenden ersten NMOS-Transistor und einer Reihenschaltung aus zwei zwischen Masse und einem zweiten Datenausgang liegenden zweiten und dritten NMOS-Transistoren gebildet, wobei Gate des zweiten NMOS-Transistors mit Gate des ersten NMOS-Transistors und Gate des dritten NMOS-Transistors mit Source bzw. Drain des ersten NMOS-Transistors verbunden sind. Es sei ausdrücklich angemerkt, daß eine solche Eingabeschaltung auch getrennt von der Ansteuerschaltung eingesetzt werden kann, wenn mit einfachen Mitteln ein Signal und ein zu diesem invertiertes Signal erzeugt werden sollen.

Die erfindungsgemäße Ansteuerschaltung läßt sich mit wenigen Bauelementen auf kleiner Fläche realisieren, so daß sie auf engstem Raum im Raster der Speichermatrix der Halbleiter-Speicheranordnung untergebracht werden kann. Die Eingabeschaltung ist aus lediglich drei NMOS-Transistoren aufgebaut, so daß sie besonders einfach und flächengünstig zu realisieren ist, was für Halbleiter-Speicheranordnungen bzw. deren Raster von höchster Bedeutung ist. Da hier keine PMOS-Transistoren zum Einsatz kommen, kann die Eingabeschaltung in einer gemeinsamen Wanne untergebracht werden, was einen zusätzlichen Flächenvorteil bedeutet. Infolge der höheren Stromergiebigkeit der NMOS-Transistoren im Vergleich zu PMOS-Transistoren kann zudem die gesamte Schaltung besonders klein ausgelegt werden.

Die Verriegelungsschaltung kann in vorteilhafter Weise aus zwei antiparallel geschalteten Invertern bestehen.

Nachfolgend wird die Erfindung anhand der Zeichnungen näher erläutert. Es zeigen:
- Fig. 1: ein Schaltbild der erfindungsgemäßen Ansteuerschaltung;
- Fig. 2: ein CMOS-Transfergate;
- Fig. 3: ein Schnittbild einer Stapel-Gate-Zelle;
- Fig. 4: ein Schnittbild einer Split-Gate-Zelle, und
- Fig. 5: eine Speicherzellenmatrix mit Wortleitungen und Bitleitungen.

Die Fig. 3 bis 5 sind bereits eingangs erläutert worden.

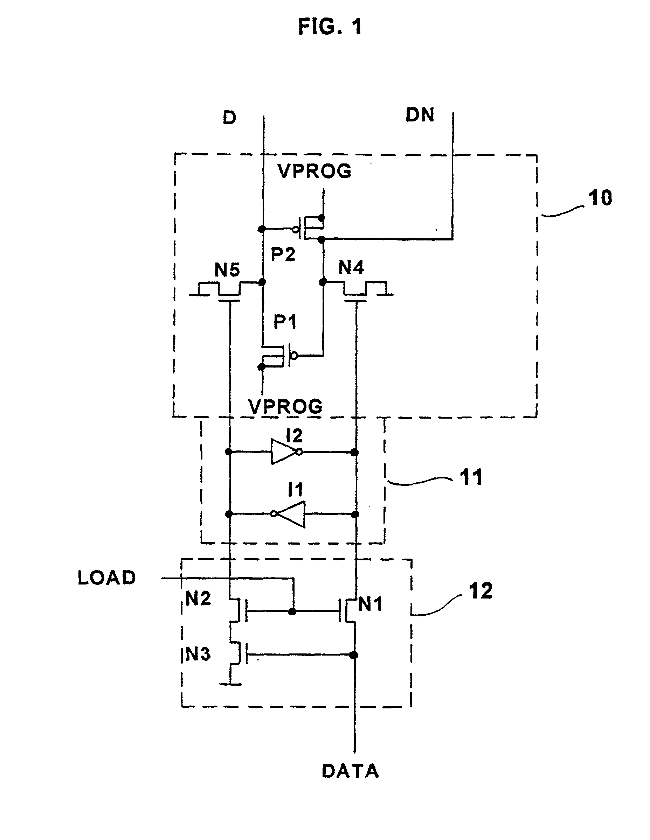

Fig. 1 zeigt den Schaltungsaufbau einer erfindungsgemäßen Ansteuerschaltung. Diese Ansteuerschaltung besteht aus einer Pegelwandlerschaltung 10, einer Verriegelungsschaltung (Latch) 11 und einer Eingabeschaltung 12. Die Pegelwandlerschaltung 10 besteht aus PMOS-Transistoren P1, P2 und NMOS-Transistoren N4, N5 und weist Ausgangsanschlüsse D bzw. DN auf, die mit den Bitleitungen bzw. Wortleitungen einer Halbleiter-Speicheranordnung verbunden sind. Die Ausgangsleitungen D bzw. DN stellen je nach einem Eingangswert von "1" bzw. "0", der an einem Eingang DATA liegt, eine Spannung VPROG bzw. 0 V zur Verfügung. Dabei ist der Ausgangsanschluß DN komplementär zu dem Ausgangsanschluß D und liefert 0 V bzw. eine Spannung VPROG, wenn am Ausgangsanschluß D eine Spannung V von VPROG bzw. 0 V anliegt.

An Drain bzw. Source der PMOS-Transistoren P1 bzw. P2 liegt eine von außen zugeführte Spannung VPROG von beispielsweise 15 V. Mittels der Transistoren N4, N5, P1 und P2 wird die Einspeisung dieser Spannung VPROG zum Ausgangsanschluß D bzw. DN gesteuert, wobei der Ausgang DN komplementär zum Ausgang D ist, wie dies oben bereits erläutert wurde.

Eine Pegelwandlerschaltung, die zu der Pegelwandlerschaltung 10 ähnlich ist, ist aus der bereits genannten US-A-5,293,561 an sich bekannt.

Der Pegelwandlerschaltung 10 ist die Verriegelungsschaltung 11 vorgeschaltet, die aus zwei antiparallel zueinander liegenden Invertern I1 und I2 besteht. Vor dieser Verriegelungsschaltung 11 liegt eine Eingabeschaltung 12 aus drei NMOS-Transistoren N1 bis N3. Die zu speichernden Daten, also beispielsweise 5 V für einen Datenwert "1", werden über einen Eingang DATA der Eingabeschaltung zugeführt. Dabei ist Source bzw. Drain des Transistors N1 mit dem Eingang DATA verbunden, was auch für Gate des Transistors N3 gilt, der mit dem Transistor N2 in Reihe geschaltet ist. Gates der Transistoren N1 und N2 sind miteinander verbunden und an einen Anschluß LOAD angeschlossen. Liegen an dem Anschluß LOAD beispielsweise 5 V, so leiten die Transistoren N1 und N2, so daß 0 V an dem in Fig. 1 linken Eingang der Verriegelungsschaltung 11 liegen, während beispielsweise ein Datensignal "1" von 5 V über den Transistor N1 dem in Fig. 1 rechten Eingang der Verriegelungsschaltung 11 (vermindert um die Einsatzspannung des Transistors N1) zugeführt wird.

Die erfindungsgemäße Ansteuerschaltung ist besonders gut geeignet für Daten, welche in eine nichtflüchtige Halbleiter-Speicheranordnung programmiert werden sollen. Diese Daten werden in der Verriegelungsschaltung 11 zwischengespeichert, und es wird eine geregelte Spannung VPROG für jede Bitleitung zur Verfügung gestellt. Die Ansteuerschaltung wird bei dieser Anwendung getrennt für jede Bitleitung bzw. Wortleitung vorgesehen. Die zu programmierenden Daten werden an die Eingangsleitung DATA angelegt. Durch einen positiven Puls am Anschluß LOAD werden die Daten sodann in die Verriegelungsschaltung 11 übernommen. An den Ausgangsanschlüssen D und DN stellt die Pegelwandlerschaltung 10 dann je nach Eingangswert "1" bzw. "0" am Eingangsanschluß DATA die Spannung VPROG bzw. 0 V zur Verfügung. Das Signal am Ausgangsanschluß DN ist dabei kompelementär zu dem Signal am Ausgangsanschluß D und liefert 0 V bzw. eine Spannung VPROG, wenn die Spannung am Ausgangsanschluß D den Wert VPROG bzw. 0 V hat.

Selbstverständlich kann die erfindungsgemäße Ansteuerschaltung an einer Bitleitung und/oder einer Wortleitung für die allgemeine Verteilung von Hochspannungen eingesetzt werden.

Die Eingabeschaltung 12 ist lediglich aus den drei NMOS-Transistoren N1, N2 und N3 aufgebaut. Sie ist damit besonders einfach und flächendeckend günstig zu realisieren, was für Speicher-Rasterschaltungen von höchster Bedeutung ist. Da keine PMOS-Transistoren zum Einsatz kommen, kann dieser Schaltungsteil in einer gemeinsamen Wanne erzeugt werden, was einen erheblichen Flächenvorteil bedeutet. Die Eingabeschaltung 12 zieht je nach Eingabedatum den in Fig. 1 rechten Knoten der Verriegelungsschaltung über den Transistor N (am Eingangsanschluß DATA liegt "0") auf 0 V oder den linken Knoten über die Transistoren N2 und N3 auf 0 V.

Durch die höhere Stromergiebigkeit von NMOS-Transistoren im Vergleich zu PMOS-Transistoren kann die Eingabeschaltung 12 besonders klein ausgelegt werden. Speziell muß die Summe der Weite der Transistoren N2 und N3 nur maximal so groß sein wie die Weite eines PMOS-Transistors mit einem entsprechenden CMOS-Transfergate (vergleiche Fig. 2). Für die Ansteuerung der Eingabeschaltung 12 wird weiterhin nur das eine Signal LOAD benötigt. Ein zusätzliches invertiertes Signal, wie es an sich bei einem CMOS-Transfergate erforderlich ist, braucht nicht verwendet zu werden.

Die erfindungsgemäße Ansteuerschaltung benötigt keinen zusätzlichen Eingangsinverter für die Ansteuerung der Transistoren N4 und N5, sondern es wird hierfür die Funktion der Inverter I1 und I2 der Verriegelungsschaltung ausgenutzt. Die vorteilhafte Kombination der Verriegelungsschaltung 11 mit der Pegelwandlerschaltung 10 spart somit Bauelemente ein und ist deshalb besonders für den Einsatz in flächenkritischen Speicherrasterschaltungen geeignet.

## Patentansprüche

1. Ansteuerschaltung für eine nichtflüchtige Halbleiterspeicheranordnung,
mit einer Pegelwandlerschaltung (10), die einen Ausgangswert (D) und einen zu diesem Ausgangswert komplementären Ausgangswert (DN) an eine Bitleitung und/oder eine Wortleitung der Halbleiterspeicheranordnung anlegt,
mit einer zwischen einer Eingabeschaltung (12) und der Pegelwandlerschaltung (10) liegenden Verriegelungsschaltung (Latch) (11), die die in der Halbleiterspeicheranordnung zu speichernden Daten zwischenspeichert,
**dadurch gekennzeichnet**,
daß die Eingabeschaltung (12) aus einem mit seiner Source-Drain-Strecke zwischen einem Dateneingang (DATA) und einem ersten, mit einem Steuereingang der Pegelwandlerschaltung (10) verbundenen Datenausgang liegenden ersten NMOS-Transistor (N1) und einer Reihenschaltung aus zwei zwischen Masse und einem zweiten, mit einem zum Steueranschluß komplementären Steueranschluß der Pegelwandlerschaltung (10) verbundenen Datenausgang liegenden zweiten und dritten NMOS-Transistoren (N2, N3) besteht, wobei Gate des zweiten NMOS-Transistors (N2) mit Gate des ersten NMOS-Transistors (N1) und Gate des dritten NMOS-Transistors (N3) mit dem Dateneingang (DATA) verbunden sind.

2. Ansteuerschaltung nach Anspruch 1,
**dadurch gekennzeichnet**,
daß die Verriegelungsschaltung (11) aus zwei antiparallel geschalteten Invertern (I1, I2) besteht.

## Claims

1. Drive circuit for a non-volatile semiconductor storage arrangement, having a level converter circuit (10) which applies an output value (D) and an output value (DN) complementary to this output value to a bit line and/or a word line of the semiconductor storage arrangement, with a latch circuit (11) which lies between an input circuit (12) and the level converter circuit (10) and temporarily stores the data to be stored in the semiconductor storage arrangement, characterized in that the input cicuit (12) consists of a first NMOS transistor (N1) with its source-drain path lying between a data input (DATA) and a first data output connected to a control input of the level converter circuit (10), and a series circuit consisting of two second and third NMOS transistors (N2, N3) lying between earth and a second data output which is connected to a control connection of the level converter circuit (10) and is complementary to the control connection, the gate of the second NMOS transistor (N2) being connected to the gate of the first NMOS transistor (N1) and the gate of the third NMOS transistor (N3) being connected to the data input (DATA).

2. Drive circuit according to Claim 1, characterized in that the latch circuit (11) consists of two inverters (I1, I2) connected in antiparallel.

## Revendications

1. Circuit de pilotage pour un agencement de mémoire non volatile à semiconducteur,
avec un circuit convertisseur de niveau (10), qui applique une valeur de sortie (D) et une valeur de sortie (DN), complémentaire de cette valeur de sortie, sur une ligne de bits et/ou sur une ligne de mots de l'agencement de mémoire à semiconducteur,
avec, placé entre un circuit d'entrée (12) et le circuit convertisseur de niveau (10), un circuit de verrouillage (latch) (11), qui mémorise en tampon les données à mémoriser dans l'agencement de mémoire à semi-conducteur,
**caractérisé par le fait**
que le circuit d'entrée (12) se compose d'un premier transistor NMOS (N1), monté avec sa ligne source-drain entre une entrée de données (DATA) et une première sortie de données, reliée à une entrée de commande du circuit convertisseur de niveau (10), et d'un circuit série de deux deuxième et troisième transistors NMOS (N2, N3), montés entre la masse et une deuxième sortie de données, reliée à une borne de commande du circuit convertisseur de niveau (10) complémentaire de la borne de commande, la grille du deuxième transistor NMOS (N2) étant reliée à la grille du premier transistor NMOS (N1) et la grille du troisième transistor NMOS (N3) étant reliée à l'entrée de données (DATA).

2. Circuit de pilotage selon la revendication 1
**caractérisé par le fait**
que le circuit de verrouillage (11) se compose de deux inverseurs binaires (I1, I2) montés en antiparallèle.
